Europäisches Patentamt

(19) European Patent Office

Office européen des brevets

(11) Publication number : **0 095 887 B2**

## (12) NEW EUROPEAN PATENT SPECIFICATION

(45) Date of publication of the new patent specification : **28.08.91 Bulletin 91/35**

(51) Int. Cl.$^5$ : **C23C 14/00, C23C 16/00**

(21) Application number : **83302990.3**

(22) Date of filing : **24.05.83**

(54) **Apparatus for plasma chemical vapour deposition.**

(30) Priority : **28.05.82 JP 90678/82**

(43) Date of publication of application : **07.12.83 Bulletin 83/49**

(45) Publication of the grant of the patent : **23.12.87 Bulletin 87/52**

(45) Mention of the opposition decision : **28.08.91 Bulletin 91/35**

(84) Designated Contracting States : **DE FR GB**

(56) References cited :
JP-A- 5 320 951
US-A- 3 757 733
US-A- 3 893 876
US-A- 4 224 897
US-A- 4 316 430
US-A- 4 331 737
B.Mattson, T.Thompson: "Productivity Increase in a Planar Plasma Deposition System", Solid State Technology, November 1979, pages 81-84
K.Akitmoto, K. Watanabe , Appl. Phys. Lett., 39(5), 1 September 1981, pages 445-447

(73) Proprietor : **FUJITSU LIMITED**
**1015, Kamikodanaka Nakahara-ku**
**Kawasaki-shi Kanagawa 211 (JP)**

(72) Inventor : **Shioya, Yoshimi**
**16-6-402, Namiki 1-chome**
**Kanazawa-ku Yokohama-shi Kanagawa 236 (JP)**
Inventor : **Takagi, Mikio**
**6-20-3 Nagao**
**Tama-ku Kawasaki-shi Kanagawa 213 (JP)**
Inventor : **Maeda, Mamoru**
**5-6-403 Toyogaoka 2-chome**
**Tama-shi Tokyo 206 (JP)**
Inventor : **Ohyama, Yasushi**
**2-755 Hanakoganei**
**Kodaira-shi Tokyo 187 (JP)**

(74) Representative : **Rackham, Stephen Neil et al**
**GILL JENNINGS & EVERY 53-64 Chancery Lane**
**London WC2A 1HN (GB)**

EP 0 095 887 B2

## Description

The invention relates to an apparatus for plasma chemical vapour deposition (hereinbelow, the chemical vapour deposition is referred to as CVD). The present invention has particular use in a plasma CVD apparatus in which a silicide or metal film for a circuit pattern is formed onto a substrate for an integrated circuit.

An apparatus for vapour deposition on a substrate is shown in US-A-4224897 and comprises a plasma treatment chamber having an evacuation opening to maintain the interior of the plasma treatment chamber at a desired reduced pressure, a gas feed pipe extending from the exterior into the inside of the plasma treatment chamber, for introducing the compound gas into the plasma treating chamber, and two electrodes, disposed substantially parallel to each other in the plasma treatment chamber, for applying high sequency electric power to generate a plasma. In this apparatus the homogeneous nucleation of vapour species in the gaseous environment in the plasma treatment chamber is suppressed by heating the gaseous environment.

A low temperature plasma CVD apparatus has often been employed to form a silicide or metal film for use as a gate electrode or wiring material of an integrated circuit.

Such an apparatus employs a gas of a compound which is liquid at room temperature, such as an inorganic fluoride compound, molybdenum fluoride ($MoF_6$), or tungsten fluoride ($WF_6$), or trimethyl aluminium $AL(CH_3)_3$, or titanium tetrachloride ($TiCl_4$). These compounds vaporise at room temperature and, thus, do not have to be heated. Gases of these compounds, however, may often condense on the wall of a gas feeding pipe provided on the apparatus and this affects the reproducibility of the plasma CVD by affecting the flow conditions.

In the case of the use of a gas of a compound which is solid at room temperature, such as aluminium chloride, ($ALCl_3$), molybdenum chloride ($MoCl_5$, tungsten chloride ($WCl_5$ or $WCl_6$) or another inorganic chloride compound, the gas of the compound may solidify in the gas feeding pipe of the apparatus, thus affect the reproducibility in plasma CVD or block the gas feeding pipe.

Because of the above, a conventional plasma CVD apparatus can only use a limited range of compounds for the feeding gas. This can prevent the formation of a deposited film of a satisfactory adhesion strength or good quality.

A particular example of an apparatus in accordance with this invention will now be described with reference to the accompanying drawings, in which :-

Figure 1 is a diagrammatic cross-section of the apparatus ;

Figure 2 is a perspective view of a heating means ; and,

Figure 3 is a graph illustrating the relationship between the carrier gas flow rate and the growth rate of a deposited film.

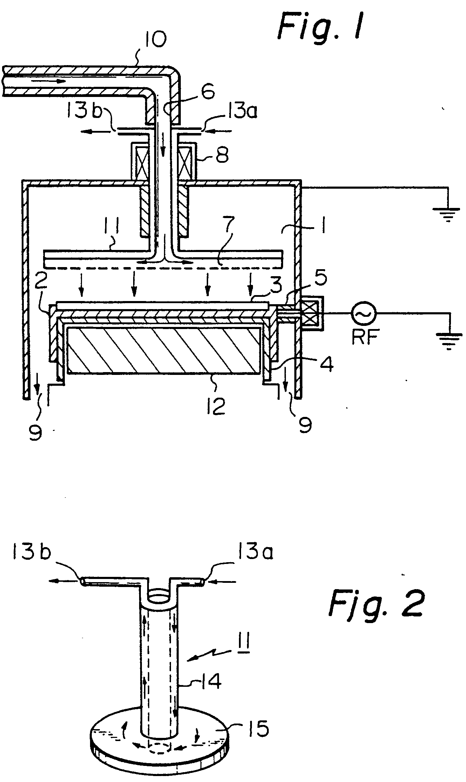

Referring now to Figure 1, the plasma CVD apparatus comprises a chamber 1, a susceptor 2 for supporting a substrate 3 to be treated, and a gas feeding pipe 6 leading from a gas source (not shown) through the gas inlet portion of the chamber into the inside of the chamber 1 and connected to a gas outlet member 7 in the inside of the chamber 1. The susceptor 2 is connected to a radiofrequency source (RF), thus forming a radiofrequency electrode. The susceptor 2 may thus advantageously be made of aluminum or stainless steel and is electrically insulated from the system by insulating members 4 and 5 made of an insulating material such as quartz. Under the insulating member 4, there is located a heater 12 for heating the susceptor 2 and, thus, the substrate 3 to be treated. The susceptor 2 may optionally be rotated.

The gas feeding pipe 6 is provided with a heating cover 10 for heating the pipe 6 in a region from the gas source (not shown) to the gas inlet portion of the chamber 1 and a heating jacket 11 for heating the pipe 6 in a region from the gas inlet portion of the chamber to the gas outlet member 7 in the inside of the chamber and also heating the gas outlet member 7. The apparatus has a sealing member 8 at the gas inlet portion of the chamber 1. The heating cover may be of a type including an electrical resistance heater.

In the apparatus, a silicide or metal film is formed onto a substrate 3 located on the susceptor 2 by applying a radiofrequency voltage between the radiofrequency electrode system consisting of the susceptor 2 and the electrode system consisting of the gas outlet member 7 to generate plasma and convert the gas into activated particles. The chamber 1 is evacuated through evacuation openings 9 to maintain the inside of the chamber at a desired pressure.

In the course of study leading to this invention, the inventors first developed a plasma CVD apparatus as illustrated in Fig. 1 having only the heating cover 10 but not having the heating jacket 11. They found, however, that such an apparatus was still insufficient to solve the problems as mentioned hereinbefore. Therefore, the inventors made further extensive studies and achieved the above-mentioned apparatus according to the present invention.

Thus, the apparatus according to the present invention has a heating means, such as the heating jacket 11 in Fig. 1, for heating the gas feeding pipe leading from the gas inlet portion of the chamber to the gas outlet member in the inside of the chamber and for heating the gas outlet member in addition to a heating means, such as the heating cover 10 in Fig. 1, for heating the gas feeding pipe leading from the gas source to the gas inlet portion of the chamber. The heating jacket 11 shown in Fig. 1 may have a construction as illustrated in Fig. 2. The jacket 11 comprises a double cylindrical member 14 which has a cavity at the peripheral portion and a circular bottom plate 15 which also has a cavity connected to the cavity of the double cylindrical member 14. A heating medium such as hot air is introduced into the jacket 11 through the inlet 13a and removed from the outlet 13b, thereby heating the gas feeding pipe contacted with the double cylindrical member 14 and the gas outlet member contacted with the bottom plate 15.

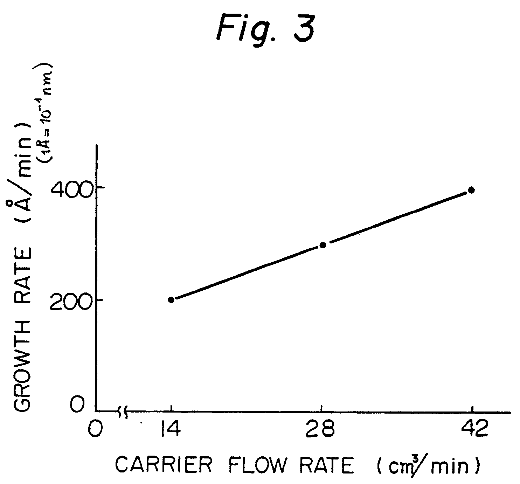

Using the apparatus as illustrated in Fig. 1, a molybdenum film was deposited onto, for example, an insulating layer on a single-crystal silicon wafer. A gas of molybdenum chloride ($MoCl_5$) was heated to a temperature of 100°C to 120°C and fed into the chamber 1. Argon gas was used as carrier gas. The gas feeding pipe 6 and the was outlet member 7 were heated to 150°C by means of the heating cover 10 and the heating jacket 11. The chamber was evacuated to a pressure of (1 torr. 133.3 Pa and the temperature of the wafer surface was 400°C. The resultant growth rate of the molybdenum film in relation to the flow rate of the carrier gas is seen from the graph of Fig. 3.

According to the plasma CVD apparatus of the present invention, plasma CVD can stably be carried out using a gas of a compound which is liquid at room temperature, such as molybdenum fluoride, tungsten fluoride, trimethyl aluminum, or titanium tetrachloride, or using a gas of a compound which is solid at room temperature, such as aluminum chloride, molybdenum chloride, or tungsten chloride. Thus, various deposited films of metal silicides or metals can be formed onto a substrate for an integrated circuit with an excellent reproducibility. Further, according to the present invention, a silicide or metal film of a high adhesion strength and high quality can be formed.

US-A-4331737 describes an apparatus for plasma chemical vapour deposition on a base body using a gas of a compound which is solid or liquid at room temperature the compound gas being converted into a plasma state, comprising a plasma treatment chamber having an evacuation opening to maintain the interior of the plasma treatment chamber at a desired reduced pressure, a gas feed pipe extending from the exterior into the inside of the plasma treatment chamber, for introducing the compound gas into the plasma treating chamber, two electrodes, disposed substantially parallel to each other in the plasma treatment chamber, for applying high frequency electric power to generate a plasma, one of the two electrodes being a susceptor for supporting the base body, and a heating cover in heat conductive contact with a portion of the gas feed pipe on the outside of the plasma treatment chamber.

According to this invention such an apparatus is characterised in that the gas feed pipe leads to a gas outlet member in the inside of the plasma treatment chamber, in that the other of the two electrodes is the gas outlet member, and in that the apparatus also includes a heating jacket in heat conductive contact with the gas feed pipe and in heat conductive contact with the gas outlet member, the heating jacket heating the gas feed pipe and the gas outlet member to prevent the compound gas from condensing or solidifying in them, the heating jacket including :

a bottom plate in heat conductive contact with the gas outlet member, and having a first cavity ; and,

a double cylindrical member having a second cavity connected to the first cavity in the bottom plate and capable of receiving a heating medium, the double cylindrical member extending from the bottom plate and being in heat conductive contact with the gas feed pipe inside the plasma treatment chamber.

## Claims

1. An apparatus for plasma chemical vapour deposition on a base body (3) using a gas of a compound which is solid or liquid at room temperature, the compound gas being converted into a plasma state, comprising a plasma treatment chamber (1) having an evacuation opening (9) to maintain the interior of the plasma treatment chamber (1) at a desired reduced pressure, a gas feed pipe (6) extending from the exterior into the inside of the plasma treatment chamber (1), for introducing the compound gas into the plasma treating chamber (1), two electrodes (2,7), disposed substantially parallel to each other in the plasma treatment chamber (1), for applying high frequency electric power to generate a plasma, one of the two electrodes being a susceptor (2) for supporting the base body (3), and a heating cover (10) in heat conductive contact with a portion of the gas feed pipe (6) on the outside of the plasma treatment chamber (1) ;

characterised in that the gas feed pipe (6) leads to a gas outlet member (7) in the inside of the plasma treatment chamber (1), in that the other of the two electrodes is the gas outlet member (7), and in that the apparatus also includes a heating jacket (11) in heat conductive contact with the gas feed pipe (6) and in heat conductive contact with the gas outlet member (7), the heating jacket (11) heating the gas feed pipe (6) and the gas outlet member (7) to prevent the compound gas from condensing or solidifying in them, the heating jacket including :

a bottom plate (15) in heat conductive contact with the gas outlet member (7), and having a first cavity ; and,

a double cylindrical member (14) having a second cavity connected to the first cavity in the bottom plate and capable of receiving a heating medium, the double cylindrical member extending from the bottom plate and being in heat conductive contact with the gas feed pipe (6) inside the plasma treatment chamber (1).

2. An apparatus according to claim 1, wherein the heating cover (10) comprises an electrical resistance heater.

3. An apparatus according to any one of the preceding claims, further comprising a heater (12) for heating the susceptor (2).

4. An apparatus according to any one of the preceding claims, in which the susceptor (2) is arranged to be rotated.

## Patentansprüche

1. Vorrichtung zur chemischen Plasmadampfabscheidung auf einen Basiskörper (3), unter Verwendung eines Gases aus einer Verbindung, die bei Raumtemperatur fest oder flüssig ist, wobei das Verbindungsgas in einen Plasmazustand umgewandelt wird, mit einer Plasmabehandlungskammer (1), die eine Evakuierungsöffnung (9) hat, um das Innere der Plasmabehandlungskammer (1) auf einem gewünschsten reduzierten Druck zu halten, einer Gaszuführungsleitung (6), die sich von dem Äußeren in das Innere der Plasmabehandlungskammer (1) erstreckt, um das Verbindungsgas in die Plasmabehandlungskammer (1) einzuführen, und zwei Elektroden (2, 7) die im wesentlichen parallel zueinander in der Plasmabehandlungskammer (1) angeordnet sind, um hochfrequente elektrische Energie anzuwenden, um ein Plasma zu erzeugen, wobei eine der zwei Elektroden ein Susceptor (2) ist, um den Basiskörper (3) zu unterstützen, und mit einer Heizabdeckung (10) in wärmeleitendem Kontakt mit einem Abschnitt der Gaszuführungsleitung (6) an der Außenseite der Plasmabehandlungskammer (1),

dadurch gekennzeichnet, daß die Gaszuführungsleitung (6) zu einem Gasauslaßteil (7) in dem Inneren der Plasmabehandlungskammer (1) führt, daß die andere der beiden Elektroden ein Gasauslaßteil (7) ist, und daß die Vorrichtung ferner einen Heizmantel (11), in wärmeleitendem Kontakt mit der Gaszuführungsleitung (6) und in wärmeleitendem Kontakt mit dem Gasauslaßteil (7), umfaßt, wobei der Heizmantel (11) die Gaszuführungsleitung (6) und das Gasauslaßteil (7) aufheizt, um zu verhindern, daß das Verbindungsgas in ihnen kondensiert oder sich verfestigt, und bei der der Heizmantel umfaßt :

ein Bodenplatte (15), in wärmeleitendem Kontakt mit dem Gasauslaßteil (7) und mit einem ersten Hohlraum ;

ein doppeltzylindrisches Teil (14), das einen zweiten Hohlraum hat, der mit dem ersten Hohlraum in der Bodenplatte verbunden ist und ein Heizmedium aufnehmen kann, wobei das doppeltzylindrische Teil sich von der Bodenplatte erstreckt und in wärmeleitendem Kontakt mit der Gaszuführungsleitung (6) innerhalb der Plasmabehandlungskammer (1) ist.

2. Vorrichtung nach Anspruch 1, bei der die Heizabdeckung (10) einen elektrischen Widerstandsheizer umfaßt.

3. Vorrichtung nach einem der vorhergehenden Ansprüche, ferner mit einem Heizer (12) zum Heizen des Susceptors (2).

4. Vorrichtung nach einem der vorhergehenden Ansprüche, bei dem der Susceptor (2) so andeordnet ist, daß er rotiert werden kann.

## Revendications

1. Appareil de dépôt chimique en phase vapeur par plasma sur un corps de base (3), qui utilise un gaz d'un composé qui est solide ou liquide à la température ambiante, le gaz du composé étant mis à l'état de plasma, l'appareil comportant une chambre de traitement par plasma (1) ayant une ouverture d'évacuation (9) pour maintenir l'intérieur de la chambre de traitement par plasma (1) à une pression réduite voulue, un tube d'arrivée de gaz (6) allant de l'extérieur jusqu'à l'intérieur de la chambre de traitement par plasma (1) pour introduire le gaz du composé dans la chambre de traitement par plasma (1), deux électrodes (2, 7) disposées parallèlement entre elles dans la chambre de traitement par plasma (1) pour appliquer une puissance électrique haute fréquence afin de produire un plasma, l'une des deux électrodes étant un suscepteur (2) qui porte le corps de base (3), et un revêtement chauffant (10) qui est en contact de conduction de chaleur avec une partie du tube d'arrivée de gaz (6) à l'extérieur de la chambre de traitement par plasma (1),

caractérisé en ce que le tube d'arrivée de gaz (6) aboutit à un élément de délivrance de gaz (7) situé à l'intérieur de la chambre de traitement par plasma (1), en ce que l'autre des deux électrodes est l'élément de délivrance de gaz (7), et en ce que l'appareil comporte également une chemise chauffante (11) qui est en contact de conduction de chaleur avec le tube d'arrivée de gaz (6) et en contact de conduction de chaleur avec l'élément de délivrance de gaz (7), la chemise chauffante (11) chauffant le tube d'arrivée de gaz (6) et l'élément de délivrance de gaz (7) pour empêcher que le gaz du composé ne se condense ou ne se solidifie à l'intérieur de ceux-ci, la chemise chauffante comportant :

une plaque inférieure (15) qui est en contact de conduction de chaleur avec l'élément de délivrance de gaz (7) et possède une première cavité ;

un élément cylindrique double (14) possédant une seconde cavité reliée à la première cavité de la plaque inférieure et pouvant recevoir un agent de chauffage, le double élément cylindrique s'étendant depuis la plaque inférieure et étant en contact de conduction de chaleur avec le tube d'arrivée de gaz (6) à l'intérieur de la chambre de traitement par plasma (1).

2. Appareil selon la revendication 1, dans lequel le revêtement chauffant (10) consiste en un élément chauffant à résistance électrique.

3. Appareil selon l'une quelconque des revendications précédentes, comprenant en outre un élément chauffant (12) servant à chauffer le suscepteur (2).

4. Appareil selon l'une quelconque des revendications précédentes dans lequel le suscepteur (2) est conçu de manière à pouvoir être mis en rotation.

*Fig. 1*

*Fig. 2*

## Fig. 3